(19) Europäisches Patentamt

European Patent Office

Office européen des brevets

(11) **EP 1 387 177 A2**

(12) **EUROPÄISCHE PATENTANMELDUNG**

(43) Veröffentlichungstag:
**04.02.2004 Patentblatt 2004/06**

(51) Int Cl.⁷: **G01R 31/36**

(21) Anmeldenummer: **03016201.0**

(22) Anmeldetag: **17.07.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **26.07.2002 DE 10234032**

(71) Anmelder: **VB Autobatterie GmbH**
**30419 Hannover (DE)**

(72) Erfinder:
• **Laig-Hörstebrock, Helmut, Dr.Dipl.-Phys.**
  **60320 Frankfurt (DE)**
• **Meissner, Eberhard, Dr.Dipl.-Phys.**
  **31515 Wunstorf (DE)**

(74) Vertreter: **Lins, Edgar, Dipl.-Phys. Dr.jur. et al**
**Gramm, Lins & Partner GbR,**
**Theodor-Heuss-Strasse 1**
**38122 Braunschweig (DE)**

(54) **Energiespeicher und Verfahren zur Ermittlung des Verschleisses eines elektrochemischen Energiespeichers**

(57) Bei einem Verfahren zur Ermittlung des Verschleißes eines elektrochemischen Energiespeichers durch

- Bestimmen der Batterietemperatur (T) und

- Bestimmen einer Verschleißgröße ($Q_V$) über die Zeit (t) in Abhängigkeit von der Batterietemperatur (T),

wird die Verschleißgröße ($Q_v$) als Summe über die Zeit (t) von temperaturabhängigen Verschleißbeiträgen ($q_v$) bestimmt, wobei die Werte der Verschleißbeiträge ($q_v$) mit steigender Batterietemperatur (T) überproportional ansteigen.

EP 1 387 177 A2

**Beschreibung**

Die Erfindung betrifft ein Verfahren zur Ermittlung des Verschleißes eines elektrochemischen Energiespeichers durch

- Bestimmen der Temperatur und
- Bestimmen einer Verschleißgröße über die Zeit in Abhängigkeit von der Batterietemperatur.

Die Erfindung betrifft weiterhin einen Energiespeicher, insbesondere eine Speicherbatterie für Kraftfahrzeuge, mit Temperaturmessmitteln und mit Rechenmitteln, sowie ein mit einem elektrochemischen Energiespeicher versehenes System.

Energiespeicher, beispielsweise wiederaufladbare elektrochemische Speicherbatterien, unterliegen einem Verschleiß insbesondere beim Entlade- und Ladebetrieb. Neben dem Entlade- und Ladebetrieb gibt es auch andere, den Verschleiß von elektrochemischen Energiespeichern beschleunigende Betriebsbedingungen. Dazu gehört zum Beispiel beim Bleiakkumulator die gesamte Betriebsdauer, das heißt die gesamte seit der Inbetriebnahme verstrichene Zeit einschließlich der Perioden, in denen der Akkumulator nicht elektrisch beaufschlagt wurde.

Weiterhin können erhöhte Temperaturen den Verschleiß während der Perioden ohne elektrische Beaufschlagung und den durch zyklischen Entlade und Ladebetrieb hervorgerufenen Verschleiß verstärken.

Für den Einsatz von Energiespeichern ist es erwünscht, den Verschleiß auf Grund von Verlust an Speicherkapazität zu bestimmen. Hierbei stellt jedoch die Komplexität der Vorgänge im Energiespeicher ein Problem dar, die mit naturwissenschaftlichen Methoden nur schwer beschreibbar sind.

Beispielsweise ist in der DE 38 08 559 C2 ein Verfahren zur Überwachung der Leistungsgrenze einer Starterbatterie offenbart, bei dem durch Aufsummieren der zugeflossenen und abgeflossenen Ladungsmenge eine Ladungsmengenbilanz erstellt wird. Hieraus wird in Verbindung mit der Überwachung einer Grenz-Klemmenspannung und der Temperatur der Ladezustand der Starterbatterie bewertet. Es kann keine Aussage über die verbleibende maximale Speicherkapazität des Energiespeichers getroffen werden.

In der DE 195 40 827 A1 ist ein empirisches Verfahren zur Bestimmung des Alterungszustandes einer Batterie beschrieben, bei der ein batteriespezifisches Kennfeld der Batteriealterung vorgegeben wird. Durch Erfassen von Momentanwerten der Batteriealterungseinflussgrößen bei der überwachten Batterie wird mit Hilfe des Kennfeldes ein Batteriealterungswert ermittelt. Dabei ist unter anderem ein Koeffizient zur Berücksichtigung des Temperatureinflusses vorgesehen.

Ermittelte Alterungsanteile werden zur Bildung eines Batteriealterungswertes aufsummiert. Die Alterungsanteile werden anhand eines vorgegebenen Kennfeldes und einer laufenden Messwertüberwachung an der Batterie ermittelt. Die Alterungsanteile sind abhängig beispielsweise von Kenngrößenentlademenge pro Entladezyklus, Restladungsmenge, Geschwindigkeit der Be- oder Entladung und Temperatureinfluss.

Aus der DE 44 14 134 A 1 ist bekannt, dass die Batterietemperatur, auf die Batterielebensdauer einen starken Einfluss hat und ein exponentieller Zusammenhang zwischen Temperatur und Batterielebensdauer besteht.

In der US 6,369,578 B1 ist ein Verfahren zur Bestimmung des Zustandes einer Fahrzeugstarterbatterie beschrieben, bei dem ein Zustandswert aus der Differenz eines vorhergehenden Zustandswertes und einem Verschleißbeitrag ermittelt wird. Der Verschleißbeitrag wird aus einer Tabelle in Abhängigkeit von der maximalen Temperatur und dem minimalen Ladezustand in dem Intervall zwischen einem vorhergehenden Startvorgang und einem nachfolgenden Startvorgang bestimmt. Die Verschleißbeiträge sind hierbei so festgelegt, dass sie mit zunehmender Temperatur überproportional ansteigen und auch mit abnehmenden Ladezustand überproportional ansteigen. Mit jedem Startvorgang wird ein Verschleißbeitrag ermittelt, der jedoch nicht von der Zeitdauer seit dem letzten Startvorgang abhängt.

Die Differenzierung des Betriebszustandes in Bezug auf den temperaturabhängigen Verschleiß erfordert jedoch einen relativ komplexen Rechenalgorithmus, der in der Regel sehr speicheraufwendig ist und eine Implementierung auf einen Mikrokontroller erschwert.

Aufgabe der Erfindung war es daher, ein verbessertes Verfahren zur Ermittlung des Verschleißes eines elektrochemischen Energiespeichers zu schaffen, mit dem eine Verschleißgröße in Abhängigkeit von der Batterietemperatur relativ einfach bestimmt werden kann.

Die Aufgabe wird mit dem gattungsgemäßen Verfahren erfindungsgemäß dadurch gelöst, dass die Verschleißgröße als Summe über die Zeit von temperaturabhängigen Verschleißbeiträgen bestimmt wird, wobei die Werte der Verschleißbeiträge mit steigender Batterietemperatur überproportional ansteigen.

Es wurde erkannt, dass der Batterieverschleiß überproportional mit der Batterietemperatur ansteigt und damit der Verschleiß durch Aufsummierung von temperaturabhängigen Verschleißbeiträgen bestimmt werden kann, die entsprechend mit steigener Batterietemperatur überproportional ansteigen.

Insbesondere kann die Verschleißgröße durch eine Funktion bestimmt werden, die exponentiell mit der absoluten Temperatur anwächst.

Eine vorteilhafte Lösung kann auch darin bestehen, dass die Verschleißgröße nach Temperaturbereichen differenziert bestimmt wird, wobei die Verschleißgröße bei Temperaturen oberhalb einer oberen Grenztemperatur über die Zeit als Funktion der Batterietemperatur zunimmt.

Vorzugsweise wird der Verschleiß eines elektrochemischen Energiespeichers unmittelbar aus der Batterietemperatur über die Zeit bestimmt, wobei eine Differenzierung nach Temperaturbereichen vorgenommen wird. Dabei hat sich herausgestellt, dass oberhalb einer oberen Grenztemperatur der Verschleiß mit zunehmender Temperatur progressiv voranschreitet und der Verschleiß ohne weitere Einflussgrößen unmittelbar aus der Temperatur des Energiespeichers berechnet werden kann. Die Batterietemperatur kann relativ einfach durch Messung, Schätzung oder Berechnung, durch Ableiten aus den bekannten Temperaturen anderer Komponenten, durch Berücksichtung des Wärmeein- und -austrages durch Strahlung oder Strömung von Fluiden, durch Berücksichtigung des Wärmeeintrags durch elektrische Verlustleistung im Energiespeicher etc. bestimmt werden.

Weiterhin kann berücksichtigt werden, dass die Verschleißgröße bei Batterietemperaturen in einem Zwischenbereich zwischen einer unteren Grenztemperatur und der oberen Grenztemperatur über die Zeit unabhängig von der Batterietemperatur linear mit der Zeit zunimmt. Zudem tritt in der Regel unterhalb der unteren Grenztemperatur kein Verschleiß auf, so dass in diesem Temperaturbereich die bislang ermittelte Verschleißgröße konstant gehalten wird.

Zur Bestimmung der Verschleißgröße $Q_v$ werden vorzugsweise Verschleißbeiträge $q_v$ in Zeitintervallen dt berechnet, wobei die Zeitintervalle dt vorzugsweise jeweils in Abhängigkeit von der Batterietemperatur T so bemessen sind, dass die Batterietemperatur in definierten Toleranzbereichen konstant ist. Im Falle des nach Temperatur-Bereichen differenzierten Vorgehens sind die Zeitbereiche allerdings entsprechend der oben erwähnten Temperaturintervalle festgelegt. Die Verschleißgröße $Q_v$ wird dann als Summe der Verschleißbeiträge $q_v$ der aufeinanderfolgenden Zeitintervalle dt bestimmt.

Für Batterietemperaturen oberhalb einer oberen Grenztemperatur können die Verschleißbeiträge $q_v$ progressiv mit der Batterietemperatur über die Zeit zunehmen. Für Batterietemperaturen in dem Zwischenbereich oberhalb der unteren Grenztemperaturen und unterhalb der oberen Grenztemperaturen können die Verschleißbeiträge $q_v$ linear mit der Zeit unabhängig von der Temperatur zunehmen und für Batterietemperaturen unterhalb der unteren Grenztemperatur bleiben die Verschleißbeiträge $q_v$ konstant bleiben.

Die Temperaturabhängigkeit der Verschleißbeiträge $q_v$ kann in Abhängigkeit vom Batteriesystem sehr verschiedene Formen haben. Ein häufig gültiger Ansatz ist:

$$q_v = K_0 * c * exp(-E/T)dt,$$

wobei die Verschleißgröße $Q_v$ aus den Verschleißbeiträgen $q_v$ nach der Formel

$$Q_v = \sum q_v$$

berechnet wird und wobei $K_0$ ein Proportionalitätsfaktor ist, in dem sich vorteilhafterweise die Kapazität des Energiespeichers abbildet, und c ein dimensionsloser Faktor ist. Die Größe E hat die Bedeutung einer Aktivierungstemperatur mit der Dimension grd.

Es bietet sich auch häufig an, die Temperaturabhängigkeit der Verschleißbeiträge $q_v$ vereinfacht zum Beispiel durch Differenzierung der Temperaturbereiche darzustellen, wobei mindestens einer der Temperaturbereiche eine überproportionale Temperaturabhängigkeit aufweist. Beispielsweise können die nach Temperaturbereichen aufgeteilten temperaturabhängigen Verschleißbeiträge $q_v$ nach den Formeln

$$q_v = K_0 * A * (1 + a * T + b * T^2)dt$$

für $T \geq T_0$

$$q_v = K_0 * B * (T - T_1)dt$$

für $T_1, < T < T_0$

$$q_v = 0$$

für $T \leq T_1$

berechnet werden, wobei der Koeffizient $K_0$ ein Proportionalitätsfaktor ist, in dem sich vorteilhaft die Kapazität des Energiespeichers abbildet. Die Koeffizienten A und B sind Proportionalitätsfaktoren, die für verschiedene Temperaturbereiche unterschiedlich gewählt werden können. Die Batterietemperatur T in Kelvin [K] und die Zeit t in Stunden [h] sind die Variablen der Gleichungen.

Die Parameter A, B, a, b haben die folgenden Dimensionen: A [$h^{-1}$], a [$grd^{-1}$], b [$grd^{-2}$], B [$grd^{-1}/h$]. Die Grenztemperaturen $T_1$ und $T_0$ werden in Kelvin [K] gemessen.

Häufig wirken in den Temperaturbereichen unterschiedliche Verschleißmechanismen. Deshalb können die Konstanten c und E bzw. A, B, a, b in verschiedenen Temperaturbereichen unterschiedliche Werte haben.

Aus einer derart bestimmten Verschleißgröße $Q_v$ kann die Speicherfähigkeit des elektrochemischen Energiespeichers vorteilhaft dadurch bestimmt werden, dass die Verschleißgröße $Q_v$ auf die Speicherfähigkeit $Q_N$ des Energiespeichers zu einem früheren Zeitpunkt als der für die Verschleißgröße $Q_v$ geltende Zeitpunkt bezogen wird. Als Bezug wird vorzugsweise die Speicherfähigkeit des Energiespeichers im Neuzustand, das heißt die Anfangskapazität des Energiespeichers gewählt.

Die aktuelle Speicherfähigkeit des elektrochemischen Energiespeichers kann dann aus der Differenz der Anfangskapazität des Energiespeichers im Neuzustand und der Verschleißgröße bestimmt werden.

Damit ist die aktuelle Speicherfähigkeit mit geringem Rechenaufwand und einfacher kontinuierlicher Temperaturmessung relativ zuverlässig bestimmbar.

Besonders vorteilhaft ist es, die berechnete Verschleißgröße mit weiteren Zustandsgrößen, die den Zustand des Energiespeichers beschreiben, zu verknüpfen und hieraus eine verknüpfte Verschleißgröße $Q_v$ zu bestimmen. Die weiteren Zustandsgrößen können mit einem oder mehreren anderen Verfahren zur Ermittlung des Verschleißes eines elektrochemischen Energiespeichers bestimmt werden. Vorzugsweise werden Verfahren eingesetzt, die andere zum Verschleiß von elektrochemischen Energiespeichern beitragende Effekte als die Temperaturabhängigkeit des zeitbedingten Verschleißes berücksichtigen. Durch Subtrahieren der verknüpften Verschleißgröße von der Anfangskapazität des elektrochemischen Energiespeichers kann ein Maß für die aktuelle Speicherfähigkeit berechnet werden.

Die Aufgabe wird weiterhin durch einen Energiespeicher gelöst, bei dem Rechenmittel zur Berechnung der Verschleißgröße als Funktion der gemessenen Batterietemperatur nach dem oben beschriebenen Verfahren beispielsweise durch geeignete Programmierung eines Mikroprozessor- oder Mikrocontrollersystems. ausgebildet sind. Weiterhin wird die Aufgabe durch ein System gelöst, welches mit einem elektrochemischen Energiespeicher ausgerüstet ist, bei dem Rechenmittel zur Berechnung der Verschleißgröße als Funktion der gemessenen Batterietemperatur nach dem oben beschriebenen Verfahren beispielsweise durch geeignete Programmierung eines Mikroprozessor- oder Mikrocontrollersystems ausgebildet sind.

Die Erfindung wird nachfolgend anhand von Ausführungsbeispielen näher erläutert.

In Abhängigkeit von der aktuellen Batterietemperatur T wird ein differentieller Verschleißbeitrag $q_v$ bestimmt. Durch Aufsummieren der Verschleißbeiträge $Q_v$ wird eine Verschleißgröße $Q_v$ ermittelt, die das Zeitintegral der differentiellen Verschleißbeiträge $q_v$ ist. Diese Verschleißgröße $Q_v$ ist verknüpft mit der Kapazität der Speicherbatterie im Neuzustand ein Maß für die Speicherfähigkeit des Energiespeichers.

Beispiel 1:

Es hat sich gezeigt, dass bei höheren Batterietemperaturen T oberhalb einer oberen Grenztemperatur $T_0$ in einem Zeitintervall dt einer bestimmten Dauer ein mit steigender Batterietemperatur T progressiv ansteigender Verschleiß zu beobachten ist. Bei mittleren Batterietemperaturen T unterhalb der oberen Grenztemperatur $T_0$ und oberhalb einer unteren Grenztemperatur $T_1$ ist der Verschleiß in einem Zeitintervall dt einer bestimmten Dauer linear von der Temperatur abhängig und nimmt linear mit der voranschreitenden Zeit zu. Bei tiefen Batterietemperaturen T unterhalb der unteren Grenztemperatur $T_1$ tritt kein signifikanter Verschleiß ein.

Der Verschleiß eines elektrochemischen Energiespeichers wird somit differenziert nach den genannten Temperaturbereichen ermittelt. Für Zeitintervalle dt, in denen innerhalb eines Toleranzbereichs annähernd gleiche Temperaturen T vorliegen, werden Verschleißbeiträge $q_v$ nach den folgenden Formeln berechnet:

$$q_v = K_0 * A * (1 + a * T + b * T^2)\, dt$$

für $T \geq T_0$

$$q_v = K_0 * B(T - T_1)\, dt$$

für $T_1 < T < T_0$

$$q_v = 0$$

für $T \leq T_1$.

Dabei ist $K_0$ ein Proportionalitätsfaktor, der vorteilhaft die Batteriegröße, die Batteriekapazität o. ä. abbildet und für die verschiedenen Temperaturbereiche unterschiedlich gewählt werden kann. Vorzugsweise wird der Proportionalitätsfaktor $K_0$ jedoch für alle Temperaturen gleich der Speicherfähigkeit $Q_N$ des Energiespeichers im Neuzustand gewählt. Der Proportionalitätsfaktor $K_0$ entspricht dann der Anfangskapazität des Energiespeichers.

Der Zeitparameter A, der für unterschiedliche Temperaturbereiche unterschiedliche Werte annehmen kann, hat die Dimension $h^{-1}$. Der erste Temperaturkoeffizient a hat die Dimension $grd^{-1}$, der zweite Temperaturkoeffizient b hat die Dimension $grd^{-2}$. B ist ein Zeittemperaturparameter mit der Dimension $grd^{-1}/h$. Die Grenztemperaturen $T_1$ und $T_0$ werden in K gemessen. Die Variablen der oben genannten Gleichungen sind die Temperatur T in °C und die Zeit t in Stunden [h]. Die Temperatur des Energiespeichers kann unmittelbar an dem Energiespeicher gemessen, aus anderen Größen geschätzt oder berechnet werden. Die Batterietemperatur T kann aus bekannten Temperaturen anderer Komponenten abgeleitet werden. Es kann auch der Wärmeeintrag und Wärmeaustrag durch Strahlung oder Strömung von Fluiden berücksichtigt oder der Wärmeeintrag durch elektrische Verlustleistung im Energiespeicher berücksichtigt werden. Weitere Methoden zur Bestimmung einer Batterietemperatur T sind gleichermaßen einsetzbar.

Es wurde nun erkannt, dass die aus der Summe der Verschleißbeiträge $q_v$ berechnete Verschleißgröße $Q_V$ den Verlust an Speicherfähigkeit eines elektrochemischen Energiespeichers ausdrückt. Die aktuelle Speicherfähigkeit kann somit aus der Verschleißgröße $Q_V$ bestimmt werden, indem die Verschleißgröße $Q_V$ auf die Speicherfähigkeit $Q_N$ des Energiespeichers zu einem früheren Zeitpunkt bezogen wird, beispielsweise auf die Anfangskapazität des Energiespeichers im Neuzustand. Zu diesem Zeitpunkt wird die Verschleißgröße $Q_V$ vorzugsweise auf den Wert Null gesetzt. Durch kontinuierliche Bestimmung der Verschleißgröße $Q_V$ beginnend vom Neuzustand während des gesamten Betriebs eines Energiespeichers kann somit durch einfache Temperaturmessung mit geringem Rechenaufwand die aktuelle Speicherfähigkeit des Energiespeichers bestimmt werden. Hierzu wird lediglich die Differenz der Verschleißgröße $Q_V$ zu der Speicherfähigkeit $Q_N$ des Energiespeichers zu dem früheren Zeitpunkt, vorzugsweise der Anfangskapazität im Neuzustand, berechnet.

Für einen Bleiakkumulator haben sich folgende Parameter- und Koeffizientenwerte als vorteilhaft herausgestellt:

Zeitparameter A = 2,8· $10^{-5}$ [$h^{-1}$]
erster Temperaturkoeffizient a = -5,7 · $10^{-2}$[$grd^{-1}$]
zweiter Temperaturkoeffizient b = 1,1 · $10^{-3}$[$grd^{-2}$]
Zeittemperaturparameter B = 2,7 · $10^{-7}$ [$grd^{-1}$/h]
untere Grenztemperatur $T_1$ = 0°C = 273 K
obere Grenztemperatur $T_0$ = 25°C = 298 K.

Beispiel 2:

Im Falle der Beschreibung der Verschleißbeiträge $q_v$ mit der obenen beschriebenen Exponentialfunktion wurde zum Beispiel für einen Bleiakkumulator gefunden, das für den Verschleiß die Konstanten c = 123 und E = 5000 grd einen guten Richtwert darstellen, so dass sich ein Verschleißbeitrag von $Q_v$ = 132 * $K_0$ [Ah] * exp (-5000/T) als Verlust pro Stunde [h] in [Ah/h] ergibt. Nimmt man zum Beispiel einen Temperaturverlauf an der Speicherbatterie pro Tag von 22h mit 25°C und 2h mit 60°C an, so ergibt sich das Verhältnis von Verschleißgröße $Q_v$ zu dem Proportionalitätsfaktor $Q_V$/$K_0$ zu 8,4% pro Jahr.

Da es neben dem Temperatureinfluss auch andere zum Verschleiß von elektrochemischen Energiespeichern beitragende Effekte gibt, wie zum Beispiel Ladungsdurchsatz, ist es vorteilhaft, die Verschleißgröße $Q_V$ mit weiteren Zustandsgrößen zu verknüpfen, die mit anderen Verfahren zur Ermittlung des Verschleißes ermittelt wurden, insbesondere Verfahren, die andere zum Verschleiß beitragende Effekte als den Temperatureinfluss berücksichtigen.

**Patentansprüche**

1. Verfahren zur Ermittlung des Verschleißes eines elektrochemischen Energiespeichers durch

   - Bestimmen der Batterietemperatur (T) und
   - Bestimmen einer Verschleißgröße ($Q_V$) über die Zeit (t) in Abhängigkeit der Batterietemperatur (T),

   **dadurch gekennzeichnet, dass**
   die Verschleißgröße ($Q_V$) als Summe über die Zeit (t) von temperaturabhängigen Verschleißbeiträgen ($q_v$) bestimmt wird, wobei die Werte der Verschleißbeiträge ($q_v$) mit steigender Batterietemperatur (T) überproportional ansteigen.

2. Verfahren nach Anspruch 1, **dadurch gekennzeichnet, dass** die Verschleißgröße ($Q_v$) von der Batterietemperatur (T) nach der Formel

$$Q_V = K_0 * c * exp(-E/T)dt$$

   abhängig ist, wobei T ein etwa der Batterietemperatur entsprechender Wert, $K_0$ ein festgelegter Proportionalitätsfaktor, c und E definierte Konstanten und dt ein Zeitintervall sind.

3. Verfahren nach Anspruch 1 oder 2, **dadurch gekennzeichnet, dass** die Abhängigkeit der Verschleißgröße ($Q_v$) von der Batterietemperatur (T) nach Temperaturbereichen differenziert wird.

4. Verfahren nach einem der vorhergehenden Ansprüche, **dadurch gekennzeichnet, dass** die Verschleißgröße ($Q_V$) bei Batterietemperaturen (T) zwischen einer unteren Grenztemperatur ($T_1$) und einer oberen Grenztemperatur ($T_0$) über die Zeit (t) linear von der Batterietemperatur (T) und linear mit der Zeit (t) zunimmt.

5. Verfahren nach Anspruch 4, **dadurch gekennzeichnet, dass** die Verschleißgröße ($Q_V$) bei einer Batterietemperatur (T) unterhalb der unteren Grenztemperatur ($T_1$) über die Zeit (t) konstant bleibt.

6. Verfahren nach einem der vorhergehenden Ansprüche, **gekennzeichnet durch** Berechnen von Verschleißbeiträgen ($q_v$) in Zeitintervallen (dt), wobei die Verschleißbeiträge ($q_v$) für Batterietemperaturen (T) oberhalb einer Grenztemperatur ($T_0$) überproportional mit der Batterietemperatur (T) zunehmen.

7. Verfahren nach Anspruch 6, **gekennzeichnet durch** Berechnen der Verschleißbeiträge ($q_v$) für

Batterietemperaturen (T) oberhalb einer Grenztemperatur ($T_0$) für Zeitintervalle (dt) nach der Formel

$$q_v = K_0 * A * (1 + a * T + b * T^2) \, dt,$$

wobei $K_0$ ein Proportionalitätsfaktor, A ein Zeitparameter, a ein erster Temperaturkoeffizient und b ein zweiter Temperaturkoeffizient ist.

8. Verfahren nach Anspruch 6 oder 7, **gekennzeichnet durch** Berechnen der Verschleißbeiträge ($q_v$) für Batterietemperaturen (T) unterhalb der oberen Grenztemperatur ($T_0$) für Zeitintervalle (dt) nach der Formel

$$q_v = K_0 * B(T - T_1) \, dt,$$

wobei $K_0$ ein Proportionalitätsfaktor und ein B ein Zeitparameter ist.

9. Verfahren nach Anspruch 6 oder 7, **gekennzeichnet durch** Berechnen der Verschleißbeiträge ($q_v$) für Batterietemperaturen (T) oberhalb der unteren Grenztemperatur ($T_1$) und unterhalb der oberen Grenztemperatur ($T_0$) für Zeitintervalle (dt) nach der Formel

$$q_v = K_0 * B(T - T_1) \, dt,$$

wobei $K_0$ ein Proportionalitätsfaktor und B ein Zeitparameter ist und die Verschleißbeiträge ($q_v$) für Batterietemperaturen unterhalb der unteren Grenztemperatur ($T_1$) gleich Null sind.

10. Verfahren nach einem der Ansprüche 6 bis 9, **dadurch gekennzeichnet, dass** die Verschleißbeiträge ($q_v$) in Zeitintervallen (dt) berechnet werden, wobei die Zeitintervalle (dt) jeweils in Abhängigkeit von der Batterietemperatur (T) so bemessen sind, dass die Batterietemperatur (T) ungefähr konstant ist.

11. Verfahren nach einem der vorhergehenden Ansprüche, **dadurch gekennzeichnet, dass** die Verschleißgröße ($Q_V$) ein **Maß** für die Speicherfähigkeit des elektrochemischen Energiespeichers ist, wobei die Verschleißgröße ($Q_V$) auf die Speicherfähigkeit ($Q_N$) des Energiespeichers zu einem früheren Zeitpunkt als den für die Verschleißgröße ($Q_V$) geltenden Zeitpunkt bezogen wird.

12. Verfahren nach Anspruch 11, **dadurch gekennzeichnet, dass** die Speicherfähigkeit ($Q_N$) des Energiespeichers zu dem früheren Zeitpunkt die Anfangskapazität im Neuzustand ist.

13. Verfahren nach Anspruch 12, **dadurch gekennzeichnet, dass** die Verschleißgröße ($Q_v$) zu dem früheren Zeitpunkt Null ist.

14. Verfahren nach einem der Ansprüche 11 bis 13, **gekennzeichnet durch** Berechnen der aktuellen Speicherfähigkeit des elektrochemischen Energiespeichers aus der Differenz der Anfangskapazität ($Q_N$) des Energiespeichers im Neuzustand und der Verschleißgröße ($Q_v$).

15. Verfahren nach einem der vorhergehenden Ansprüche, **gekennzeichnet durch** Bestimmen einer verknüpften Verschleißgröße ($Q^*_v$) aus der berechneten Verschleißgröße ($Q_v$) und weiteren Zustandsgrößen, die den Zustand des Energiespeichers beschreiben.

16. Energiespeicher, insbesondere Speicherbatterie für Kraftfahrzeuge, mit Temperaturmessmitteln und mit Rechenmitteln, **dadurch gekennzeichnet, dass** die Rechenmittel zu Berechnung einer Verschleißgröße ($Q_v$) als Funktion der gemessenen Batterietemperatur nach dem Verfahren nach einem der vorhergehenden Ansprüche ausgebildet sind.

17. Mit einem elektrochemischen Energiespeicher versehenes System, insbesondere Kraftfahrzeug, mit Temperaturmessmitteln und mit Rechenmitteln, **dadurch gekennzeichnet, dass** die Rechenmittel zu Berechnung einer Verschleißgröße ($Q_v$) als Funktion der gemessenen Batterietemperatur nach dem Verfahren nach einem der vorhergehenden Ansprüche ausgebildet sind.